# EUROPEAN PATENT APPLICATION

(11) **EP 3 667 717 A1**
(43) Date of publication of application: **17.06.2020**
(21) Application number: 18211482.7
(22) Date of filing: 11.12.2018
(51) Int. Cl.: H01L 23/24, H01L 23/26

(54) **POWER ELECTRONIC MODULE**

(71) Applicant: ABB Schweiz AG, 5400 Baden (CH)
(72) Inventor: Manninen, Jorma, 00380 Helsinki (FI); Silvennoinen, Mika, 00380 Helsinki (FI); Pakarinen, Joni, 00380 Helsinki (FI)
(74) Representative: Kolster Oy Ab

(57) **Abstract**

A power electronic module comprising a substrate, one or more power semiconductor chips attached to the substrate, a gel-like compound applied on the substrate and the one or more power semiconductor chips, and a housing covering the substrate, the one or more power semiconductor chips and the gel-like compound. The power electronic module comprises further corrosion inhibitor substance arranged inside the housing.

## Description

### FIELD OF THE INVENTION

The present invention relates to power electronic modules.

### BACKGROUND OF THE INVENTION

Power electronic modules are electrical components in which multiple of power electronic semiconductor switches are incorporated in a single housing. A power electronic module may have, for example, three or six controllable semiconductor switches and their antiparallel diodes. The electrical components in a module are internally connected together for a certain use. The components may, for example, be connected to form a half-bridge or a similar commonly use circuit structure. The internal wiring of the components enable to design and produce low-impedance current paths to minimize the losses of the circuit.

The components of a module are typically attached by soldering or sintering to a substrate, such as a direct bonded copper substrate. This substrate, with the semiconductor chips forming the components, is then enclosed in a housing which gives the components physical protection. Some modules also include a base plate to which the bottom side of the substrate is attached for removing heat from the components. The base plate is attached further to a heat sink. There are also power electronic modules without a base plate. In connection with such modules, a heat sink is directly attached to the bottom surface of the substrate for removing the heat.

Inside the housing the semiconductor chips and the top surface of the substrate is covered with a gel-like substance which is electrically insulating and gives protection against humidity and pollutants which may enter the housing. Typically the substance on top of the chips and the substrate is either silicone gel or epoxy. Although the semiconductor chips are somewhat protected inside the housing against solid particles and liquids, the protection of the semiconductors in not sufficient especially in industrial environments where the amount of gaseous contaminants can be high. Gaseous contaminants are known to increase the chemical corrosion of the semiconductor chips. The corrosion has a direct impact on the service life of the components.

### BRIEF DESCRIPTION OF THE INVENTION

An object of the present invention is to provide a power electronic module so as to solve the above problem. The objects of the invention is achieved by a power electronic module which is characterized by what is stated in the independent claim. The preferred embodiments of the invention are disclosed in the dependent claims.

The invention is based on the idea of employing corrosion inhibitors inside a power electronic module housing. The corrosion inhibitors react against corrosion agents which penetrate inside the housing. The invention provides thus protection against chemical corrosion of the power semiconductor chips and other metallic parts inside the housing.

An advantage of the power electronic module of the invention is that the service life of the power electronic module is increased although the module is used in heavy atmosphere containing pollutants.

### BRIEF DESCRIPTION OF THE DRAWINGS

In the following the invention will be described in greater detail by means of preferred embodiments with reference to the attached drawings, in which

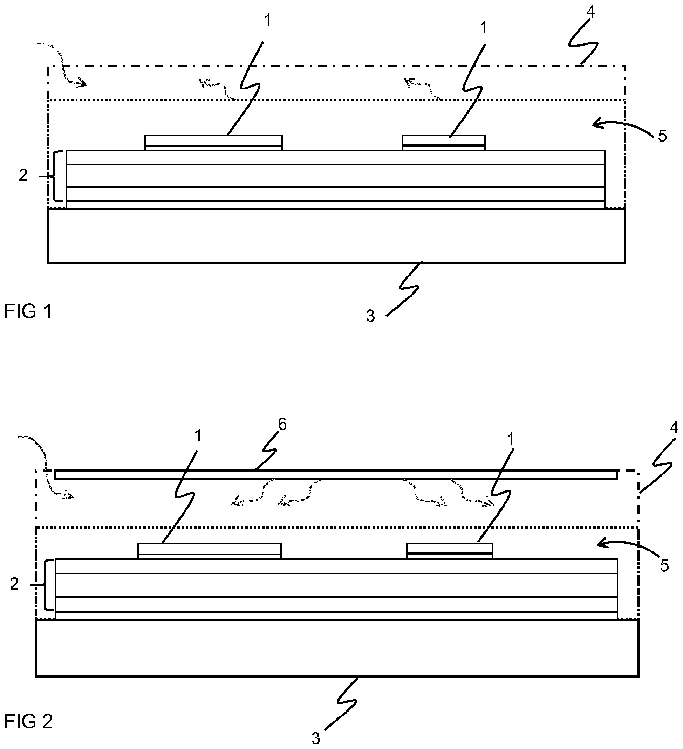

Figures 1, 2, 3 and 4 show embodiments of the present invention.

### DETAILED DESCRIPTION OF THE INVENTION

Figure 1 shows an example of a cross section of power electronic module of the invention. The cross section is taken in position in which two semiconductor chips 1 are present. Figure 1 also shows a substrate 2 which can be of direct bonded copper (DBC) type, the substrate is further attached to a base plate 3 of the module. Thus in a typical manner, the power semiconductor chips 1 are attached to a substrate 2, and the substrate is attached to a base plate 3. The combination of the substrate and the semiconductor chips is covered by a housing 4 as shown in Figure 1. The housing extends in the sides of the module to the surface of the base plate 3. In power electronic modules without a base plate the cover is attached to the sides of the substrate. Figure 1 further shows a gel-like compound 5 on top of the substrate 2 and the power semiconductor chips 1. The gel-like compound is shown to have a rectangular cross-section. It is, however clear, that the cross-section of the actual gel-like compound may have another shape.

According to the invention, the power electronic module comprises further corrosion inhibitor substance arranged inside the housing. In the embodiment of Figure 1, the corrosion inhibitor substance is added to the gel-like compound 5. The gel-like compound is typically silicone gel or epoxy. The corrosion inhibitor added to the gel-like compound reacts with the corrosion agents as they enter the gel-like compound from the air inside the power module housing or package. The gel-like compound may also contain volatile corrosion inhibitor that is emitted into the air space inside the housing of the module. This way the inhibitor compound can react with the airborne corrosion agents. The corrosion inhibitor substance can be mixed in the gel-like compound completely, i.e. such that the substance is equally distributed inside the compound. The corrosion inhibitor can alternatively be added only to certain parts of the gel-like compound. The used corrosion inhibitor may not mix evenly in the gel-like compound, and therefore it may be advisable to place the inhibitor only to a selected part of the compound. When the corrosion inhibitor is a chemical, it may be advisable that it is mixed with the gel-like compound as it mixes there substantially evenly.

Figure 2 shows another embodiment of the invention. Similarly as Figure 1, a cross section of a power electronic module is shown. The reference numerals correspond in Figure 2 to those of Figure 1. In the embodiment of Figure 2, the corrosion inhibitor substance 6 is added to inner surface of the housing. The corrosion inhibitor substance 6 is shown as a layer inside the housing and attached to an inner surface of the housing 4. Corrosion inhibitor substance can be doped in plastic housing, and the inner surface of the housing can be formed of the doped plastic material. In the embodiment, the corrosion inhibitor is volatile corrosion inhibitor which emits substances inside the airspace of the power electronic module and thereby reacts with the corrosion agents which have penetrated inside the housing. It is to be noted, that in the embodiment of Figure 2 also the gel-like substance is placed on top of the substrate to protect the substrate against moist and physical particles, for example. It is also possible to employ corrosion inhibitors both in the gel-like substance and in the inner surface of the housing.

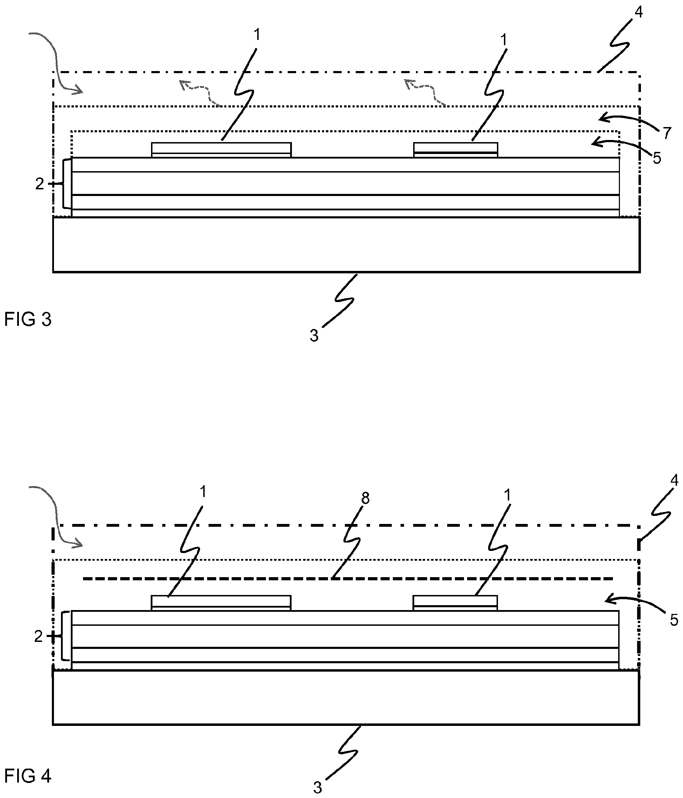

Figure 3 shows another embodiment of the present invention. In the embodiment, a gel-like compound 5 is placed on top of the substrate 2 and the chips 1. The gel-like compound 5 in the embodiment is the type of compound which is typically used and the purpose of the gel-like compound is to protect the substrate and the chips against moist and physical particles, for example. According to the embodiment, the power electronic module comprises another layer of gel-like compound 7 with corrosion inhibitor substance on top of the first layer of gel-like compound. That is, in the invention gel-like compounds are placed inside the power electronic module in layers. The layer in contact with the surface of the substrate is without corrosion inhibitors, i.e. a conventional gel layer, and the layer on top of the conventional layer contains corrosion inhibitors. When the gel-like layers are placed as in the embodiment, the functionality of the conventional gel is not compromised. When corrosion inhibitor substances are added to the gel-like compound, the electrical resistivity or thermal properties of the compound may change. Thus when conventional gel-like compound is placed on top of the surface of the substrate, the thermal and electrical properties are not compromised. In the embodiment, the corrosion inhibitor may also be volatile corrosion inhibitor.

Figure 4 shows yet another embodiment of the invention. In the embodiment a gel-like compound is added on top of the substrate 2 and the chips 1. A corrosion inhibitor is situated as a layer 8 inside the gel-like compound 5. The structure is preferably formed such that a first part of gel-like compound of conventional type is placed on top of the substrate and chips. After the first part, corrosion inhibitor substance is provided on top of the applied gel-like compound. When the corrosion inhibitor substance layer is applied, a second part of the gel-like compound is applied. Thus a layer 8 of corrosion inhibitor substance is provided inside a gel-like compound. The layers of gel-like compound form a uniform gel structure in which the corrosion inhibitor substance is fastened. As in connection with the embodiment of Figure 3, the conventional gel-like compound, like silicone gel, is in contact with the surface of the substrate and has known thermal and electrical properties. As mentioned above, the corrosion inhibitor substance can be place only in certain parts of the gel-like substance. In the embodiment, the corrosion inhibitor is not mixed evenly but is placed in certain part of the gel-like substance.

The corrosion agents which typically increase the chemical corrosion of the metallic parts inside the housing of a power electronic module include pollutants such as SO₂, O₂, O₃, NO₂, Cl₂, HCl and HCHO. These pollutants penetrate easily inside the structure of a power electronic module and increase the pace of chemical corrosion of electrical parts. Examples of corrosion inhibitors which are applicable in the present invention include amines, monohexyl and dihexyl phosphates, hydroxyethylheptadecenylglyoxalidine i.e. 2-(heptadecenyl)-4,5-dihydro-1H-imidazole-1-ethanol, and benzotriazole. Also zinc phosphate, and compounds derived from tannic acids or zinc salts of organonitrogens, like Alcophor® 827, could be used in corrosion inhibitor.

The invention can be employed with all types of power electronic modules and the presented examples are not limiting. Further, as mentioned above, the invention is not limited to power electronic modules having a base plate, but can also be employed in connection with power electronic modules without a base plate.

It will be obvious to a person skilled in the art that the inventive concept can be implemented in various ways. The invention and its embodiments are not limited to the examples described above but may vary within the scope of the claims.

## Claims

1. A power electronic module comprising
a substrate,
one or more power semiconductor chips attached to the substrate,
a gel-like compound applied on the substrate and the one or more power semiconductor chips, and
a housing covering the substrate, the one or more power semiconductor chips and the gel-like compound, **characterized in that** the power electronic module comprises further corrosion inhibitor substance arranged inside the housing.

2. A power electronic module according to claim 1 wherein the corrosion inhibitor substance is added to the gel-like compound.

3. A power electronic module according to claim 1, wherein the corrosion inhibitor substance is added on top of the gel-like compound.

4. A power electronic module according to claim 1 or 2, wherein the corrosion inhibitor substance is added as a layer to the gel-like compound.

5. A power electronic module according to claim 1 or 2, wherein the corrosion inhibitor substance is added to a selected part in the gel-like compound.

6. A power electronic module according to claim 1 or 2, wherein the corrosion inhibitor substance is added to inner surface of the housing.

7. A power electronic module according to any one of the previous claims 1 to 6, wherein the corrosion inhibitor substance is volatile corrosion inhibitor.

8. A power electronic module according to any one of the previous claims 1 to 7, wherein the corrosion inhibitor is adapted to react against corrosion agents, including sulphur dioxide.
